# EUROPEAN PATENT APPLICATION

(11) **EP 2 325 630 A2**
(43) Date of publication of application: **25.05.2011**
(21) Application number: 10188633.1
(22) Date of filing: 22.10.2010
(51) Int. Cl.: G01N 29/02, G01N 29/30, G01N 29/44, H03H 9/24, G01N 27/00, G01N 29/036

(54) **All-differential resonant nanosensor apparatus and method**

(30) Priority: 13.11.2009 US 617893
(71) Applicant: Honeywell International Inc., Morristown, NJ 07962 (US)
(72) Inventor: Cobianu, Cornel, 061672 Bucharest (RO); Serban, Bogdan, 60000 Bucharest (RO)
(74) Representative: Buckley, Guy Julian

(57) **Abstract**

An all-differential resonant nanosensor apparatus for detecting multiple gasses and method of fabricating the same. The nanosensor apparatus generally includes a sensing loop, a reference loop, and a mixer. A sensing self assembled monolayer (SAM) or an ultrathin solid monolayer may be deposited on a sensing resonant beam associated with the sensing loop to detect the presence of the gas. A reference self assembled monolayer or an ultrathin solid film may be deposited on a reference resonant beam that possess similar visco-elastic properties (e.g., temperature, humidity and aging) as the sensing monolayer with no sensing properties. A differential reading electronic circuit may be interconnected with each resonant beam pair for signal processing. A drift-free frequency signal per each gas may be obtained by subtracting the frequency response from the sensing loop and the reference loop.

## Description

### TECHNICAL FIELD

Embodiments are generally related to sensing devices and techniques. Embodiments are also related to nano-electromechanical systems (NEMS). Embodiments are additionally related to nano-resonators.

### BACKGROUND OF THE INVENTION

As the demand for energy resources increases simultaneously with the decrease in available fossil fuels, various alternative sources of energy such as coal-based energy technologies, for example, are being deployed. Such coal-based energy sources, however, generate a huge amount of toxic gases (e.g., carbon dioxide (CO₂), nitrogen dioxide (NO₂), sulfur dioxide (SO₂), etc.) which may accumulate in dangerous concentrations and negatively affect and contribute to global climate change. Large amounts of CO₂ are generated by coal gasification processes in power plants, for example, which trigger a need for carbon capture and sequestration (CCS) as well as CO₂ monitoring over large areas. The potential toxic gas emissions from such power plants have resulted in the need for gas sensors capable of being fabricated in large volumes, while offering low cost/drift/electrical power consumption and high sensitivity and selectivity when utilized to monitor air.

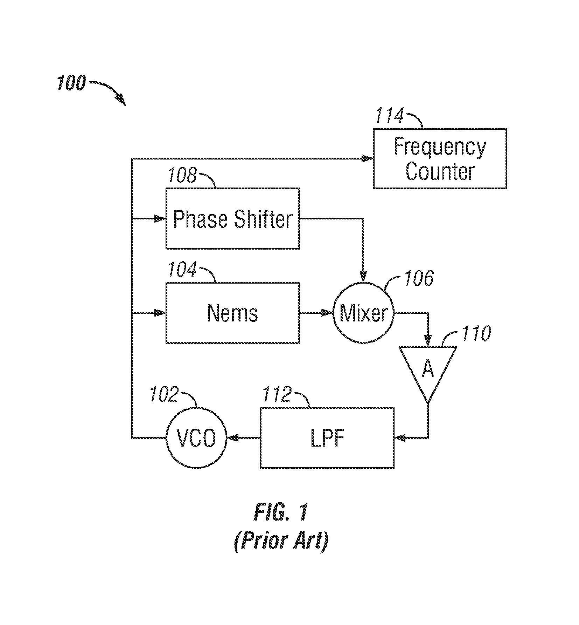

FIG. 1 illustrates a schematic diagram of a prior art resonant nano-electromechanical sensor (NEMS) 100 for detecting minuscule accreted masses deposited on the vibrating beam of the resonant NEMS 100 (i.e., nano-resonator). The NEMS 100 is driven to mechanical resonance via a Lorentz force generated by an RF electrical current flowing through a suspended beam placed in a magnetic field. The detection of the resonance frequency is performed by the amount of frequency-dependent electromotive force generated in the same nanobeam by electromagnetic induction. The sensor 100 generally includes a phase lock loop circuit that includes a voltage controlled oscillator (VCO) 102, a nano-electromechanical resonator 104, a mixer 106, a phase shifter (∅) 108, an amplifier 110, a low pass filter (LPF) 112, to which a frequency counter 114 is added. For gas detection, the surface of the vibrating beam is functionalized for selective detection of that gas. In this case, the resonant NEMS 100 operates on the principle of variation of a resonance frequency of the functionalized vibrating beam associated with the electromechanical resonator 104 as a function of the variation in a mass loading due to the gas to be detected. The measurement of the frequency shift due to mass loading variation on the vibrating beam may be performed by utilizing a classical homodyne phase lock loop (HPLL) circuit, as described above, where the VCO oscillator frequency will follow the frequency of the resonant NEMS resonator 100.

The oscillator 102 supplies a drive signal which may be adjusted accordingly by the phase shifter 108, especially for the case when a power splitter (not shown in FIG. 1) may be interposed between VCO 102 and mixer 106. The frequency-dependent electromotive force generated on the resonator 104 due to its motion may then be mixed with the VCO drive signal by the mixer 106, amplified by the amplifier 110 and low pass filtered by the filter 112. The output of the filter 112 constitutes an error signal which may be employed as a direct current (DC) signal to drive the oscillator 102 so as to follow the resonance frequency of the NEMS 104. Such a resonance frequency may then be displayed by the frequency counter 114 connected to a digital computer for data acquisition.

When using the prior art nanosensor 100 for gas sensing, problems may appear in terms of lack of long term performance stability and its poor drift behavior due to inadequate baseline stability (i.e., recovery of the sensor signal to the same response level in the absence of the gas to be detected). Other problems include its inherent temperature variations and temperature dependence of the resonance frequency, the fatigue of the vibrating beam, humidity absorption, and aging of its sensing layer, which may exhibit or contribute to the baseline drift.

Based on the foregoing, it is believed that a need exists for an improved differential resonant nanosensor apparatus for detecting a single gas or multiple gasses. A need also exists for fabricating a differential resonant nanosensor apparatus in association with a reference layer for eliminating the effects of baseline drift, as described in greater

### BRIEF SUMMARY

An "all-differential" resonant nanosensor apparatus for detecting multiple and varying gasses and a method of fabricating the same are disclosed. The disclosed nanosensor apparatus generally includes a sensing loop, a reference loop, and a mixer. The "all-differential" concept disclosed herein can apply to any type of resonant gas nanosensor, no matter what transduction principle is utilized for the actuation and/or detection of the resonance frequency and its shift as a function of the gas to be detected. A sensing self assembled monolayer (SAM) or an ultra thin solid film may be deposited on a sensing resonant beam associated with the sensing loop to detect the presence of a gas. A reference self assembled monolayer or an ultra thin solid film may be deposited on a reference resonant beam, such that the reference SAM/film possesses visco-elastic properties and temperature, humidity and aging behaviors similar to that of the sensing monolayer/film, but with no sensing properties. A differential reading electronic circuit may be interconnected with each resonant beam pair (comprising a sensing beam and a reference beam) for signal processing. A drift-free frequency signal per each gas to be detected may be obtained at the output of the mixer by subtracting the frequency response from the sensing loop and the reference loop.

The common mode signal of the sensing and the reference nano-resonators due to temperature variation, humidity adsorption, aging of the vibrating beam, and the self assembled monolayer/film may be rejected utilizing an all-differential approach with respect to the sensor and the electronic circuit. The electronic circuits associated with the sensing loop and the reference loop possess identical functional operations with a similar noise and aging response for each gas to be detected.

Ultimately, with an appropriate transduction principle, the all-differential nanosensor apparatus disclosed herein may be fully integrated on a single substrate together with the differential interrogation electronics. The apparatus may be fabricated by initially processing a wafer (e.g., complementary metal-oxide-semiconductor (CMOS) silicon on insulator (SOI)) to include elements associated with the sensing loop, the reference loop, and the electronic circuit. A suspended beam can then be released in order to form the resonant beams.

The functionalization of the sensing resonant beam and the reference resonant beam may be performed via a back-end process compatible with, for example, a CMOS SOI technology. The functionalized sensing monolayer/film and the reference monolayer/film may be deposited on the corresponding beam by a direct printing approach. The nanosensor apparatus can then be packaged utilizing a zero level packaging specific to a typical chemical sensor operation. The sensing monolayer/film and the reference monolayer may also be prepared on different substrates depending on constrains associated with a chemical functional process. The disclosed all-differential resonant nanosensor apparatus containing on-chip sensing and reference layers can therefore provide a genuine differential gas sensing application, in association with the electronic circuit.

### BRIEF DESCRIPTION OF THE DRAWINGS

FIG. 1 illustrates a schematic block diagram of a prior art resonant nano-electromechanical sensor (NEMS);

FIG. 2 illustrates a schematic block diagram of an all-differential resonant NEMS nanosensor apparatus, in accordance with the disclosed embodiments;

FIG. 3 illustrates a perspective view of an on-chip all-differential resonant nanosensor apparatus associated with a tandem of a sensing and a reference resonant beam, in accordance with the disclosed embodiments;

FIG. 4 illustrates a perspective view of a two-chip all-differential resonant nanosensor apparatus, in accordance with the disclosed embodiments;

FIG. 5 illustrates a flow chart of operations illustrating logical operational steps of a method for fabricating the all-differential resonant nanosensor apparatus, in accordance with the disclosed embodiments; and

FIG. 6 illustrates a block diagram of a direct printing system for depositing functional layers associated with the all-differential resonant nanosensor apparatus on a wafer, in accordance with the disclosed embodiments.

### DETAILED DESCRIPTION

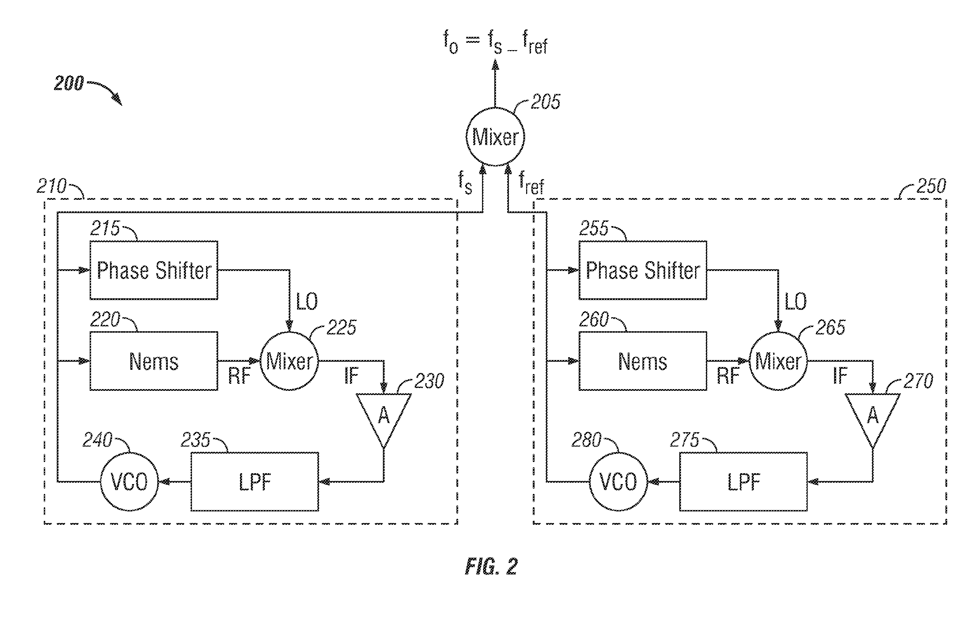

FIG. 2 illustrates a schematic block diagram of an all-differential resonant NEMS nanosensor apparatus 200, in accordance with the disclosed embodiments. Note that in FIGS. 2-6, identical or similar blocks are generally indicated by identical reference numerals. The all-differential resonant nanosensor apparatus 200 with multiple gas detection capability may be employed to detect various gasses by eliminating base line drift issues, wherein a specific surface functionalization can be employed for each gas to be detected. The apparatus 200 generally includes a sensing loop 210, a reference loop 250, and a mixer 205. The sensing loop 210 further may include a phase shifter (∅) 215, a sensing nano-electromechanical resonator 220, a mixer 225, an amplifier (A) 230, a low pass filter (LPF) 235, and a voltage control oscillator (VCO) 240. The reference loop 250 also may include a phase shifter (∅) 255, a reference nano-electromechanical resonator 260, a mixer 265, an amplifier 270, a low pass filter 275, and a voltage control oscillator 280. Note that the NEM nanoresonators 220 and 260 may be inserted in a homodyne phase locked loop (PLL) circuit for gas sensing with a NEMS. Those skilled in the art will appreciate that such an all-differential resonant sensing principle can be applied to a variety of types of electronic schemes for driving the mechanical resonance of nanobeam and monitoring the change in the resonance frequency as a function of mass loading due to the gas to be detected.

The voltage controlled oscillators 240 and 280 may track and finally detect the resonance frequency of the resonators 220 and 260, respectively, as a function of mass loading variation on the resonators 220 and 260. The measurement of the frequency shift due to mass loading variation on the nano resonator 220 may be performed by utilizing the sensing loop 210. The oscillator 240 supplies a drive signal, which may be adjusted accordingly by the phase shifter 215, in case a power splitter (not shown) is present in the signal processing circuit depicted in FIG 1. The frequency-dependent electromotive force generated on the resonator 220 due to its motion in a magnetic field (not shown in the FIGS. 1 and 2) may be mixed with the drive signal by a mixer 225, amplified by the amplifier 230, and low pass filtered by the filter 235. The output of the filter 235 constitutes an error signal which can be utilized as a direct current (DC) signal to operate the oscillator 240, which will thus track the resonance frequency of the nanoresonator 220. The nanoresonator 220 from the sensing loop 210 may be functionalized with a sensing SAM/film to measure the resonance frequency fₛ of the NEMS 220 and its change as a function of the gas to be detected along with associated drift issues.

The reference resonator 260 associated with the reference loop 250 possesses a similar response to temperature, humidity and aging with respect to the sensing loop 210, but with no sensing properties. The reference resonator 260 from the reference loop 250 may be functionalized with a reference SAM/film to measure a resonance frequency f_{ref}. The resonance frequency fₛ of sensing NEMS 220 from the sensing loop 210 may be mixed with the resonance frequency f_{ref} of the reference NEMS 260 from the reference loop 250, in order to provide a drift-free signal of frequency f₀ carrying only information regarding the gas to be detected. The common mode signal of the sensing and the reference resonators 220 and 260 due to temperature variation, humidity adsorption, and aging of the resonators 220 and 260 may be rejected by means of an all-differential approach with respect to the sensor and the electronic circuit reading level.

One or more all-differential resonant NEMS nanosensor devices 200 can be configured on the same chip, such that each apparatus 200 is dedicated for the detection of a particular gas via a proper design of the functionalized sensing SAM/film and reference SAM/film. Thus, an on-chip gas sensing array can be obtained for on-chip detection of a multitude of gases, each gas being detected by an all-differential resonant NEMS nanosensor or apparatus/device 200.

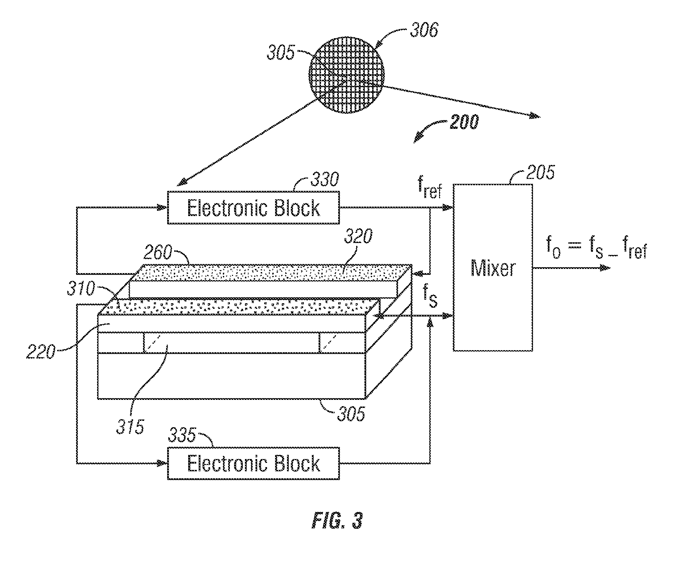

FIG. 3 illustrates a perspective view of the on-chip all-differential resonant nanosensor apparatus 200 associated with the reference resonant beam 260, in accordance with the disclosed embodiments. The differential resonator 200 can be integrated on a chip 305, as a part of a larger substrate 306 (e.g. silicon wafer) as indicated in FIG. 3 together with the differential excitation and interrogation electronic operations/components, as indicated at blocks 330 and 335. The apparatus 200, which may be dedicated for detection a single gas or multiple/varying gasses, can be configured to include the sensing resonant beam 220, the reference resonant beam 260, and the mixer 205. The sensing beam 220 further includes a sensing self assembled monolayer (SAM) or an ultrathin solid film 310 and the reference beam 260 includes a reference self assembled monolayer or an ultrathin solid film 320. The sensing monolayer 310 and the reference monolayer 320 generally include organized layers of functionalized molecules in which one end of the molecule, the "head group", displays a special covalent bond with respect to the surface of the beams 220 and 260, while the other end of the molecule can be functionalized for trapping the gas to be detected for the case of a sensing monolayer, or for not trapping the gas to be detected for the case of a reference monolayer.

The sensing monolayer/film 310 may be employed to sense ultra small concentrations of gases loading on the beam 220. The overall inertial mass of the beam 220 and the sensing monolayer 310 may be, for example, below 1 femtogram (e.g., 10⁻¹⁵ g) in order to be able to detect gas mass loading below 1 attogram (e.g., 10⁻¹⁸ g), with state of art at 100 zeptograms (i.e., note that 1 zg=10⁻²¹ g). The resonance frequency fₛ provided by the sensing resonant beam 220 includes data with respect to the gas to be detected as well as the temperature, humidity variations, gas atoms adsorption-desorption fluctuations on the resonator 220, aging of the sensing self assembled monolayer/film 310, and noise and aging of the electronic block 335. Similarly, the resonance frequency f_{ref} provided by the reference loop 250 includes data regarding temperature, humidity variations, and atom adsorption-desorption fluctuations on the resonator 260, the aging of the reference monolayer/film 320, and noise and aging of electronic block 330. The all-differential frequency shift signal obtained at the end of the mixer 205 contains only the signal indicative of the gas to be detected and thus the elimination of the sensor drift due to above described common mode signals can be appreciated.

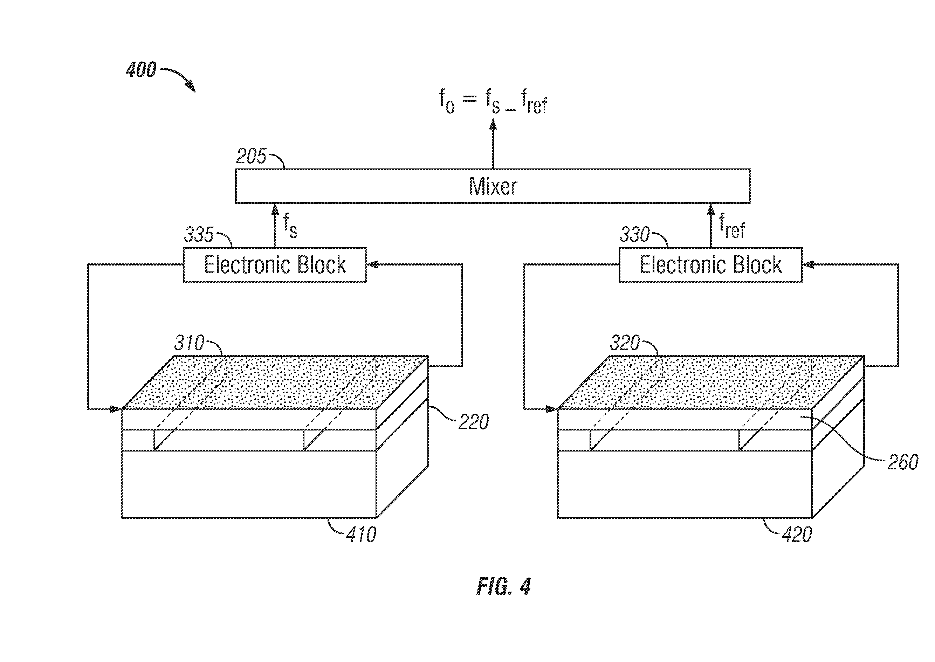

FIG. 4 illustrates a perspective view of a two-chip all-differential resonant nanosensor apparatus 400, in accordance with the disclosed embodiments. The sensing self assembled monolayer/ultrathin solid film 310 and the reference self assembled monolayer/ultrathin solid film 320 may be fabricated on different wafers depending on constrains of the chemical functional process. The sensing self assembled monolayer/ultrathin solid film 310 may be integrated on a chip 410 in association with the electronic block 335 for reading the resonance frequency fₛ. The reference self assembled monolayer/ultra thin film 320 may be integrated on the chip 420 with the similar electronic block 330 for reading the resonant frequency f_{ref}. The mixer 205 can be employed to differentiate the reference resonance frequency f_{ref} from the sensing resonance frequency fₛ to obtain the drift-free frequency signal fₒ of the gas to be detected. Note that the mixer 205 as utilized herein can be an electronic device utilized for differentiating the resonant frequencies fₛ and f_{ref}.

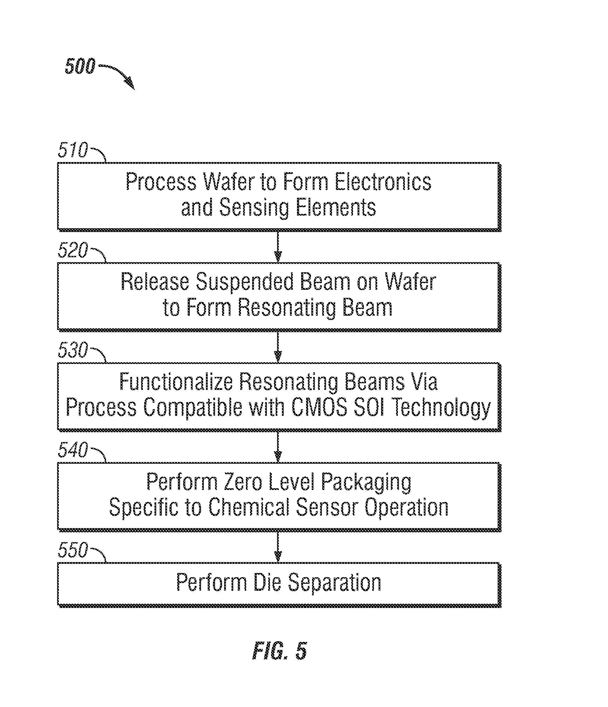

FIG. 5 illustrates a flow chart of operations illustrating logical operational steps of a method 500 for fabricating the all-differential resonant nanosensor apparatus 200, in accordance with the disclosed embodiments. The complementary metal-oxide-semiconductor silicon on insulator wafer 306 may be processed to form electronics and sensing elements associated with the nanosensor apparatus 200, as illustrated at block 510. The suspended beams 220 and 260 associated with all the chips from the wafer 306 may then be released in order to form the resonating beams, as indicated at block 520. The resonating beams can be functionalized via a process compatible with complementary metal-oxide-semiconductor (CMOS) silicon on insulator (SOI) wafer technology, as depicted at block 530. The complementary metal-oxide-semiconductor is a technology for configuring integrated circuits and the silicon-on-insulator technology refers to the use of a layered silicon-insulator-silicon substrate in place of conventional silicon substrates in semiconductor manufacturing to reduce parasitic and active device capacitance and thereby improving performance.

A zero level packaging can be performed specific to a chemical sensor operation, as illustrated at block 540. The zero level packaging or wafer level packaging may be obtained by means of wafer bonding (e.g. wafer-to-wafer). The die separation can then be performed, as indicated at block 550. The all-differential nano-sensor 200 can be fully integrated on a single chip together with the differential interrogation electronics. The sensing monolayer/ultra thin solid film 310 (i.e., monolayer or ultra thin solid film) and the reference monolayer/ultrathin solid film 320 may also be prepared on different wafers depending on constrains associated with the chemical functional process. The disclosed all-differential resonant nanosensor apparatus 200 containing on-chip sensing and reference layers can therefore provide a genuine differential gas sensing application, in association with the electronic circuit.

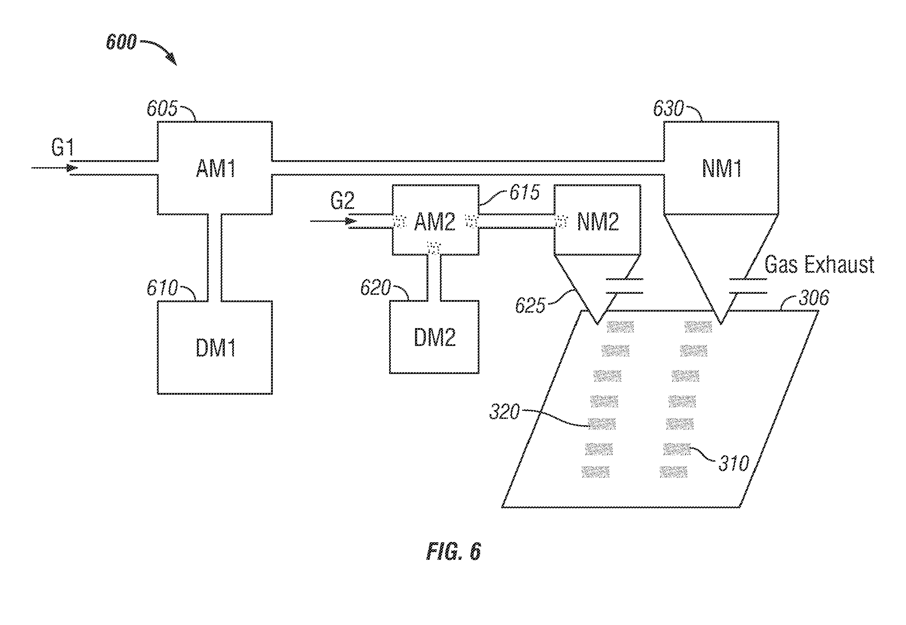

FIG. 6 illustrates a block diagram of a direct printing system 600 for depositing functional layers associated with the all-differential resonant nanosensor apparatus on a wafer 306, in accordance with the disclosed embodiments. The deposition of different types of the functionalized sensing and reference monolayer/film 310 and 320 on the same chip may be performed by using the additive, selective direct printing system 600. The direct printing system 600 may be employed to deposit the liquid solution generating the sensing self assembled monolayer/film 310 of the sensing beam 220 on the wafer 306. Similarly, the reference self assembled monolayer/film 320 liquid solution of the reference beam 260 can be deposited on the wafer 306. The direct printing system 600 generally constitutes a dual-head direct printing system wherein each type of liquid solution utilizes its own distribution system for local, selective, and additive deposition with respect to the liquid phase of the particular material.

The homogeneous liquid phase of each solution can be prepared by chemical synthesis. The silicon wafer 306 can be cleaned before liquid phase deposition. An input gas G1 can be passed through a first atomizer module AM1 605. The input gas G1 is further processed by a first deposition material DM1 610 to generate an atomized liquid solution. The atomized liquid solution can be utilized to generate multiple sensing layers 310 on the wafer 306 through a first nozzle module NM1 630 by additive deposition in the right place on the wafer 306.

Another, input gas G2 can be passed through a second atomizer module AM2 615 to get processed by a second deposition module DM2 620 to generate an atomized liquid solution of a different composition with respect to the one prepared by DM1 module 610, and which, in this case, can be that of reference monolayer/thin film 320. The atomized liquid solution can be further utilized to generate multiple reference layers on the wafer 306 through a second nozzle module NM2 625 by additive deposition in the right place on the wafer 306. Thereafter, the transition from liquid to gel phase of the functionalized layers 310 and 320 can be carried out at the end of deposition of the liquid phase on the surface. The gel ultrathin layer can then be dried for solvent removal from the gel layer. The gel layer can be thermally consolidated in order to obtain a functionalized ultrathin solid film.

The NEMS resonant gas nanosensor 200 solves the baseline drift issues by making an extensive use of the differential sensing and measuring principle. The ambient humidity and temperature variations, as well as effects stemming from aging and fatigue with respect to the beam 220 and 260, along with electronic noise in the electronic circuits 330 and 335 (a major contribution to phase noise in electronic oscillators) may contribute to the formation of a common mode signal that should be rejected from the differential sensing process. The two electronic loops 210 and 250 are identical except with respect to the sensing features of the NEMS nano-resonators 220 and the reference features of the NEMS 260 in order to reject all the common mode signals and permit only the differential sensing data to be processed and extracted.

It will be appreciated that variations of the above-disclosed and other features and functions, or alternatives thereof, may be desirably combined into many other different systems or applications, including gas sensing arrays for multi gas sensing and complex odors discrimination. Also, that various presently unforeseen or unanticipated alternatives, modifications, variations or improvements therein may be subsequently made by those skilled in the art which are also intended to be encompassed by the following claims.

## Claims

**1.** An all-differential resonant sensing apparatus, comprising:
a sensing loop including a sensing self assembled monolayer or ultra thin solid film deposited on a sensing resonant beam to detect a presence of a gas;
a reference loop including a reference self assembled monolayer or ultra thin solid film deposited on a reference resonant beam, wherein said reference self assembled monolayer possesses visco-elastic properties similar to that of said sensing loop, but lacks gas sensing properties; and
a mixer that detects a difference between a frequency response output from said sensing loop and said reference loop in order to obtain a drift-free frequency signal associated with said gas to be detected.

**2.** The apparatus of claim 1 wherein said sensing loop further comprises:
a sensing electronic circuit interconnected with said sensing resonant beam for signal processing.

**3.** The apparatus of claim 1 wherein said reference loop further comprises:
a reference electronic circuit interconnected with said reference resonant beam for signal processing.

**4.** The apparatus of claim 1 wherein said sensing self assembled monolayer or ultra thin solid film and said reference self assembled monolayer or ultra thin solid film possess similar structural responses and an aging behavior with respect to an external temperature and humidity variation.

**5.** The apparatus of claim 1 wherein said mixer rejects a common mode signal associated with said sensing loop and said reference loop in order to obtain said drift-free frequency signal associated with said gas.

**6.** An all-differential resonant sensing apparatus, comprising:
a sensing loop including a sensing self assembled monolayer or ultra thin solid film deposited on a sensing resonant beam to detect a presence of a gas;
a reference loop including a reference self assembled monolayer or ultra thin solid film deposited on a reference resonant beam, wherein said reference self assembled monolayer possesses visco-elastic properties similar to that of said sensing loop, but lacks gas sensing properties; and
a mixer that detects a difference between a frequency response output from said sensing loop and said reference loop in order to obtain a drift-free frequency signal associated with said gas to be detected and wherein said mixer rejects a common mode signal associated with said sensing loop and said reference loop in order to obtain said drift-free frequency signal associated with said gas.

**7.** The apparatus of claim 6 wherein said sensing loop further comprises:
a sensing electronic circuit interconnected with said sensing resonant beam for signal processing.

**8.** The apparatus of claim 6 wherein said reference loop further comprises:
a reference electronic circuit interconnected with said reference resonant beam for signal processing.

**8.** A method for fabricating an all-differential resonant nanosensor, said method comprising:
depositing a sensing self assembled monolayer or ultra thin solid film on a sensing resonant beam to detect a presence of gas;
forming a reference self assembled monolayer or ultra thin solid film on a reference resonant beam, wherein said reference self assembled monolayer possesses visco-elastic properties similar to that of said sensing self assembled monolayer, but lacks gas sensing properties; and
detecting a difference between a frequency response from said sensing loop and said reference loop utilizing a mixer in order to obtain a drift-free frequency signal associated with said gas to be detected.

**9.** The method of claim 8 further comprising interconnecting a sensing electronic circuit with said sensing resonant beam for signal processing.

**10.** The method of claim 8 further comprising interconnecting a reference electronic circuit interconnected with said reference resonant beam for signal processing.
